# DEMANDE DE BREVET EUROPEEN

(11) **EP 2 309 281 A1**
(43) Date de publication de la demande: **13.04.2011**
(21) Numéro de dépôt: 10186838.8
(22) Date de dépôt: 07.10.2010
(51) Int. Cl.: G01R 31/3185, H03K 3/037, H03K 3/3562

(54) **Bascule à phase d'horloge unique et à puissance dynamique réduite.**

(30) Priorité: 09.10.2009 FR 0957053
(71) Demandeur: STMicroelectronics SA, 92120 Montrouge (FR)
(72) Inventeur: Firmin, Fabian, 38400, SAINT MARTIN D'HERES (FR); Clerc, Sylvain, 38000, GRENOBLE (FR); Schoellkopf, Jean-Pierre, 38000, GRENOBLE (FR); Abouzeid, Fady, 38100, GRENOBLE (FR)
(74) Mandataire: Delprat, Olivier

(57) **Abrégé**

Cette bascule comprenant un premier étage maître de verrouillage de données (B2), un deuxième étage esclave de verrouillage de données (B3) et un circuit multiplexeur (B1) d'entrée recevant en entrée des données à verrouiller dans la bascule.

Le multiplexeur (B1) est à phase d'horloge (Cp) unique. Le premier étage maître (B2) est cadencé à partir d'une certaine phase d'horloge (Cp) alors que le deuxième étage (B3) est cadencé à partir d'une autre phase d'horloge.

## Description

L'invention concerne les bascules, notamment les bascules à rétention d'état déclenchées sur fronts (« flip-flop » en anglais).

L'invention s'applique avantageusement mais non exclusivement aux bascules à rétention d'état de type maître-esclave.

Une bascule déclenchée sur fronts est un composant couramment utilisé en microélectronique pour stocker une valeur binaire ou un « état ».

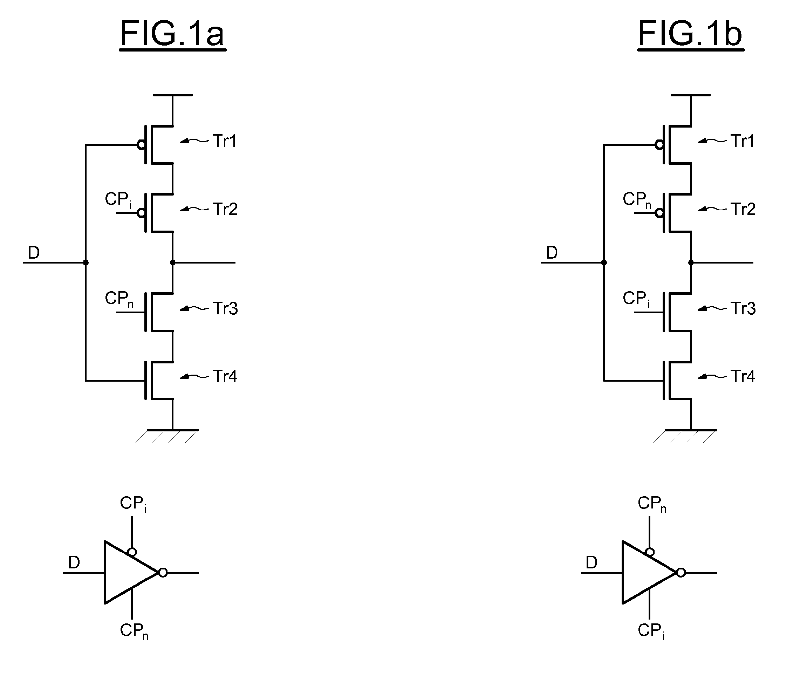

On a représenté sur la figure 1 l'architecture générale d'une telle bascule selon l'état de la technique. Comme on le voit sur cette figure, une manière courante de la réaliser est d'assembler deux mémoires de verrouillage 1a et 1b (« latch » en langue anglaise), appelées respectivement bascule maître et bascule esclave cadencées chacune par deux phases d'un signal d'horloge CPn correspondant à un signal d'horloge inversée et CPi correspondant à une recopie du signal d'horloge.

Une mémoire de verrouillage est une structure bistable composée de deux inverseurs connectés de manière à ce que le premier inverseur soit rebouclé sur son entrée par le deuxième. On utilise des inverseurs commandés par deux phases d'horloge pour rendre la structure bistable soit transparente à la donnée venant de l'extérieur, soit opaque pour cette donnée. Dans ce cas, la structure bistable mémorise et recopie la donnée précédente.

Un tel inverseur, illustré par les figures 1a et 1b, est désigné inverseur commandé double phase. Comme on le voit sur ces figures, par exemple, dans la configuration illustrée à la figure 1a, ces inverseurs commandés par horloge sont constitués respectivement d'une part de deux transistors PMOS Tr1 et Tr2 en série, l'un commandé par la donnée D et l'autre par une phase de l'horloge Cpi et, d'autre part, de deux transistors NMOS Tr3 et Tr4 en série l'un commandé par le même signal de donnée D et l'autre par une phase inverse CPn de la précédente de l'horloge.

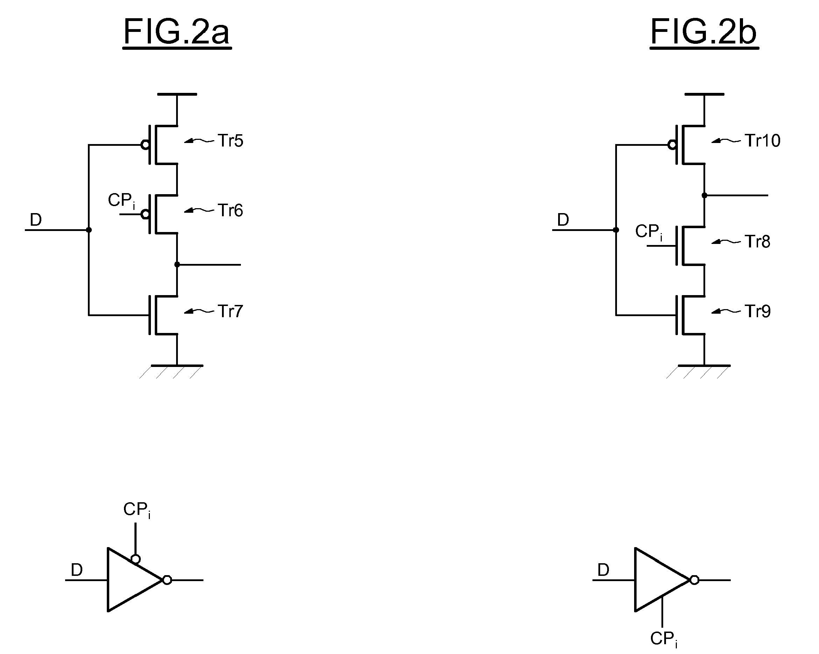

Deux alternatives à un tel dispositif peuvent également être utilisées. On a représenté sur les figures 2a et 2b ces deux alternatives, dans lesquelles, respectivement :
- l'inverseur comprend deux transistors PMOS Tr5 et Tr6 en série l'un commandé par une phase d'horloge CPi, l'autre par le signal de donnée D et un transistor NMOS Tr7 commandé par le même signal de donnée. Il s'agit d'un inverseur PMOS demi-commandé,
- l'inverseur comprend deux transistors NMOS Tr8 et Tr9 en série l'un commandé par une phase de l'horloge CPi l'autre par le signal de donnée D et un transistor PMOS Tr9 commandé par le même signal de donnée. Il s'agit d'un inverseur NMOS demi-commandé.

Ces deux alternatives illustrées dans ces figures (2a et 2b) ne nécessitent qu'une phase d'horloge.

En se référant à la figure qui illustre l'architecture d'une bascule, les signaux d'horloge CPn et CPi sont construits en passant successivement par un premier inverseur (CPn) puis par un deuxième inverseur (CPi). Il est courant en effet de régénérer la phase CPi recopiant l'horloge plutôt que d'utiliser directement le signal d'horloge en entrée pour diminuer sa capacité de charge. Ce passage par deux inverseurs augmente la consommation d'énergie du circuit liée à l'activité de l'horloge et entraîne un retard entre le signal d'horloge et les données.

Par ailleurs, les impératifs de testabilité des circuits intégrés conduisent à systématiquement utiliser un multiplexeur de débogage en entrée de Flip-Flop pour transformer, durant le test, un ensemble de Flip-Flops en registre à décalage (« scan shift register », en langue anglaise) et rendre accessible de manière statique et macroscopique les états internes du circuit. C'est la finalité du multiplexeur du registre à décalage dont le signal de sélection est le signal TE.

Il est possible de fusionner dans un seul étage CMOS les deux fonctions d'inverseur commandé et de multiplexeur de test.

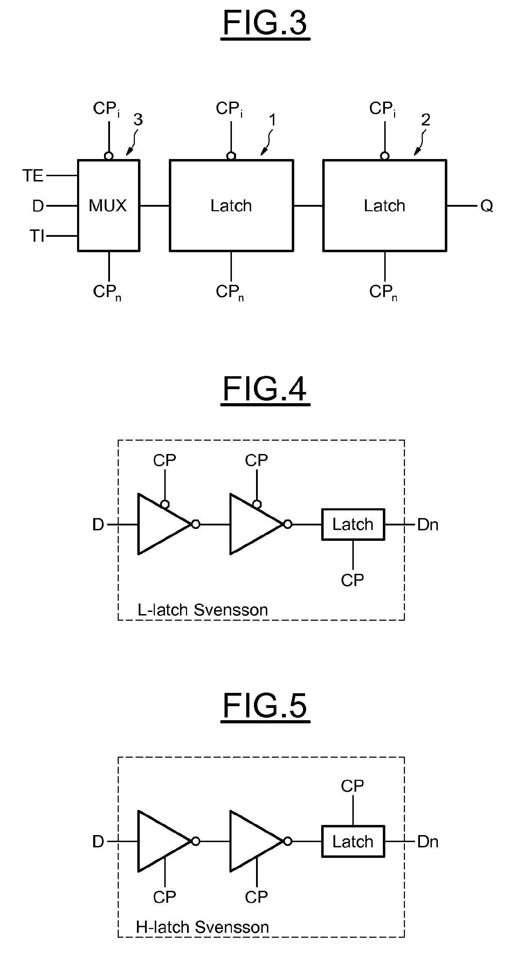

Actuellement des technologies de fabrication de composants électroniques permettent d'obtenir des circuits intégrés à vitesse élevée. Tel est le cas de la technique décrite dans la publication « Resonant-Clock latch-based-design », IEEE journal of solid-state circuits, vol43, N°4, April 2008 qui décrit une architecture de bascule permettant d'obtenir notamment des mémoires de verrouillage (« latch » en anglais) plus rapides. Pour ce faire, comme illustré sur les figures 4 et 5, qui illustrent deux modes de réalisation de latch transparente respectivement sur phase haute et phase basse d'un signal d'horloge CP, on met en série une mémoire de verrouillage à signal d'horloge unique précédée de deux inverseurs demi-commandés en série. En effet, un inverseur demi-commandé ne bloquant qu'une phase de donnée quand l'horloge est inactivée, il faut en connecter deux en série pour rendre l'ensemble opaque pour les deux phases de données.

Il est ainsi possible de faire une mémoire de verrouillage à signal d'horloge unique transparent sur un seul front d'horloge en aboutant deux verrous tels que décrit précédemment : (L-latch Svensson) (H-latch Svensson).

Au vu de ce qui précède, il est proposé de remédier aux inconvénients liés à la perte d'énergie et de vitesse de transmission des bascules tout en conservant un multiplexeur de débogage en entrée.

Il est encore proposé une bascule à rétention d'état déclenchée sur fronts comprenant en entrée, un multiplexeur de contrôle et de correction ayant des pertes d'énergie moins importantes et un retard signal d'horloge / signal de donnée moins important qu'une bascule conventionnelle.

Cette bascule comprend un premier étage maître de verrouillage des données, un deuxième étage esclave de verrouillage des données et un multiplexeur recevant des données à verrouiller dans la bascule. En outre, le multiplexeur est à phase d'horloge unique, ou mono phase d'horloge, le premier étage maître étant cadencé à partir d'un premier type de phase d'horloge et le deuxième étage esclave étant cadencé à partir d'un deuxième type de phase d'horloge.

En d'autres termes, le premier étage maître fonctionne sur une phase, par exemple la phase basse du signal d'horloge, le deuxième étage esclave étant transparent sur la deuxième phase d'horloge, par exemple la phase haute.

Le signal d'horloge unique en entrée du multiplexeur et pour toute la bascule permet d'obtenir un gain d'énergie et de temps de transmission comparé à l'état de la technique avec une bascule à deux signaux d'horloge.

Avantageusement, le premier étage de verrouillage comporte un premier inverseur placé en entrée d'une première mémoire de verrouillage. Le deuxième étage de verrouillage comporte des deuxième et troisième inverseurs placés en entrée d'une deuxième mémoire de verrouillage.

De préférence, les différents inverseurs présents dans la bascule sont des inverseurs de type MOS.

De préférence, les deux mémoires de verrouillage possèdent une fonction reset asynchrone indépendant du signal d'horloge. Cela se traduit par un changement d'état en sortie de la bascule quelque soit la phase de l'horloge et après un temps non dépendant de l'état sur de l'horloge. Pour ce faire, avantageusement, la mémoire de verrouillage du premier étage de verrouillage comporte un inverseur demi-commandé de rebouclage et une porte logique « NON ET » placés en parallèle.

De plus, la mémoire de verrouillage du deuxième étage de verrouillage comporte un inverseur demi-commandé de rebouclage et une porte logique « NON OU » placés en parallèle.

Dans un mode de réalisation, la bascule comporte un transistor NMOS dépendant du signal d'horloge placé entre le multiplexeur et le premier étage maître.

La bascule comporte aussi un transistor PMOS entre les deux inverseurs du deuxième étage esclave.

En effet, l'absence d'activité de l'horloge unique, laisse flotter le niveau de tension au point intermédiaire entre le multiplexeur et l'inverseur suivant, ce qui peut conduire par la présence de courant de fuite à un niveau de tension entre le « zéro » et le « un » logique créant un court circuit. Afin de pallier cet inconvénient, il est préférable de placer des transistors de très petite taille afin de ne pas augmenter la consommation en énergie, dans le but de fixer un potentiel en tout point du circuit.

D'autres avantages et caractéristiques de l'invention apparaîtront à l'examen de la description détaillée d'un dispositif de bascule selon un mode de réalisation et des dessins annexés sur lesquels :
- la figure 1a et 1b dont il a déjà fait mention illustre les architectures des inverseurs et demi-inverseurs commandés ;
- les figures 2a et 2b, précédemment mentionnées, illustrent des variantes des architectures des figures 1a et 1b ;
- la figure 3 illustre l'architecture générale d'une bascule à rétention d'état selon l'état de la technique ;
- les figures 4 et 5 précédemment évoquées, illustrent l'architecture générale de dispositif de verrouillage cadencée sur front descendant, et sur front montant, respectivement ;
- la figure 6 représente un schéma d'une bascule à rétention d'état déclenchée sur front selon un mode de réalisation de l'invention.

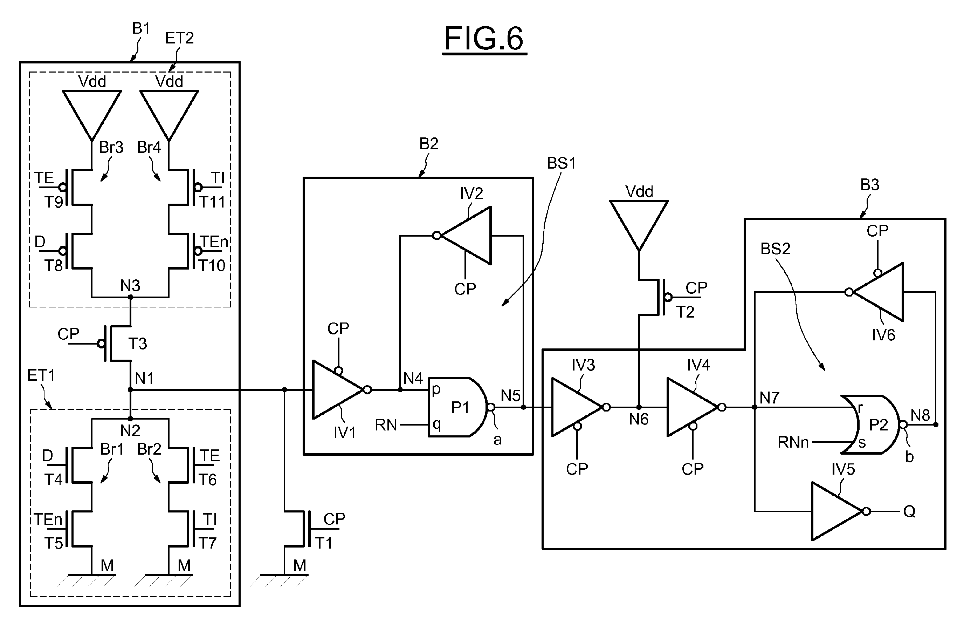

En se référant à la figure 6 qui illustre un dispositif de bascule déclenchée sur fronts montants selon un exemple de mise en oeuvre de l'invention, le dispositif comprend un bloc multiplexeur B1, un premier bloc de verrouillage B2, un deuxième bloc mémoire de verrouillage B3 raccordé en sortie du premier bloc mémoire B2, un premier transistor NMOS T1 interposé entre le bloc multiplexeur B1 et le premier bloc mémoire B2 et un deuxième transistor PMOS T2 connecté au deuxième bloc mémoire B3.

Le bloc multiplexeur B1 est un multiplexeur à deux étages basé sur l'utilisation de transistors NMOS et PMOS, fusionnant la fonction inverseur demi-commandé et la fonction multiplexeur CMOS. Il comprend un premier étage ET1 connecté entre la masse M et un noeud commun N1 de sortie et un deuxième étage ET2 connecté entre une source de tension continue Vdd et le noeud commun N3. Le bloc B1 est commandé par un signal d'horloge unique CP par l'intermédiaire d'un troisième transistor PMOS T3.

Comme on le voit sur la figure 6, le premier étage ET1 comporte deux branches BR1 et BR2 symétriques et s'étendant en parallèle entre un noeud N1 et la masse M.

Chaque branche BR1 et BR2 est formée par l'association en série de deux transistors NMOS, respectivement T4 et T5, d'une part et T6 et T7, d'autre part.

Ces transistors T4, T5, T6 et T7 sont commandés sur leur grille respectivement par les signaux D, TEn, TE et TI. Le quatrième transistor NMOS T4, connecté par son drain au drain du troisième transistor PMOS T3, est placé en série avec le cinquième transistor NMOS T5 dont la source est reliée à la masse M. Le sixième transistor NMOS T6, connecté par son drain au drain du troisième transistor PMOS T3, est placé en série avec le septième transistor NMOS T7 dont la source est reliée à la masse M.

En ce qui concerne le deuxième étage ET2, celui-ci comporte, deux branches BR3 et BR4 symétriques et parallèles s'étendant entre la source de tension continue Vdd et un noeud N3.

Chaque branche BR3 et BR4 comporte une association en série de deux transistors PMOS, respectivement T8 et T9, d'une part et T10 et T11, d'autre part.

Ces transistors T8, T9, T10 et T11 sont commandés sur leur grille respectivement par les signaux D, TE, TEn et TI. Le huitième transistor PMOS T8, connecté par son drain à la source du troisième transistor PMOS T3, est placé en série avec le neuvième transistor PMOS T9 lequel est connecté par sa source à la tension continue Vdd. Le dixième transistor PMOS T10, connecté par son drain à la source du troisième transistor PMOS T3, est placé en série avec le onzième transistor PMOS T11 dont la source est reliée à une tension continue Vdd.

L'ordre des connexions des transistors dans les différentes branches peut être changé sans modifier la fonction finale de la structure, par exemple dans la branche Br1, T4 et T5 peuvent être permutés.

Enfin, comme indiqué précédemment, le transistor T3 est connecté, par son drain au noeud N1 et par sa source au noeud N3. Sa grille reçoit le signal d'horloge Cp et devient passant sur front descendant de ce signal Cp.

De même, le premier transistor T1 est raccordé à la sortie du bloc multiplexeur B1, c'est-à-dire, par son drain au noeud commun N1, et par sa source, à la masse. Sa grille reçoit le signal d'horloge Cp et devient passant sur phase haute du signal Cp.

Ainsi, les premier et deuxième étages ET1 et ET2 sont transparents sur une phase basse d'horloge CP et transmettent la valeur de D vers le premier bloc de verrouillage B2.

Ce premier bloc B2, dont l'entrée est connectée au noeud N1, comprend un premier demi-inverseur IV1, une première porte logique P1 et un deuxième inverseur demi-commandé de rebouclage IV2. Le premier inverseur IV1 est commandé sur phase basse du signal d'horloge Cp, comme le bloc multiplexeur B1. Le premier inverseur IV1 est suivi d'un premier étage de mémorisation BS1 formé ici du deuxième inverseur IV2 et d'une première porte NON ET P1 tête bêche. Plus précisément, le deuxième inverseur IV2 fonctionne sur phase haute du signal d'horloge CP.

La première entrée « p » de la première porte NON ET P1 reçoit le signal sortant du premier inverseur IV1. La première entrée « p » a un quatrième noeud N4 commun avec la sortie du premier inverseur IV1 et celle du deuxième inverseur IV2.

La deuxième entrée « q » de la première porte NON ET P1 reçoit une commande de reset asynchrone RN. La sortie « a » de la première porte NON ET P1 et l'entrée du deuxième inverseur IV2 ont un cinquième noeud commun N5 constituant ainsi l'entrée du troisième bloc B3. Le deuxième inverseur IV2 et la première porte NON ET P1 ont un quatrième noeud N4 en commun correspondant à la sortie du premier inverseur IV1 et un cinquième noeud en commun N5 correspondant à la sortie du deuxième bloc B2.

Le deuxième bloc de verrouillage B3 comprend un troisième inverseur demi-commandé IV3, un quatrième inverseur demi-commandé IV4, un deuxième étage de mémorisation BS2 et un cinquième inverseur IV5 en sortie.

Le deuxième transistor PMOS T2 est connecté entre les troisième et quatrième inverseurs IV3 et IV4.

Le troisième inverseur IV3 est commandé par le signal d'horloge Cp. Sa sortie correspond à un sixième noeud commun N6 situé entre l'entrée du quatrième inverseur IV4 et le drain du deuxième transistor PMOS T2. Ce deuxième transistor PMOS T2 est relié par sa source à une tension continue Vdd tandis que sa grille est commandée par le signal d'horloge Cp. Enfin, le quatrième inverseur est également commandé par le signal d'horloge CP. Sa sortie correspond à un septième noeud commun N7 situé entre le deuxième étage de mémorisation BS2 et le cinquième inverseur IV5.

Le deuxième étage de mémorisation BS2 est formé ici d'un sixième inverseur demi-commandé de rebouclage IV6 et d'une deuxième porte NON OU P2 tête bêche. Le sixième inverseur IV6 est commandé sur phase basse du signal d'horloge Cp. Au septième noeud commun N7 est reliée une première entrée « r » de la deuxième porte NON OU P2 et l'entrée du cinquième inverseur IV5. Une deuxième entrée « s » de la deuxième porte NON OU P2 reçoit une commande de reset asynchrone RNn. La sortie « b » de la deuxième porte P2 à un huitième noeud N8 en commun avec l'entrée du sixième inverseur IV6.

Le cinquième inverseur IV5 dont l'entrée se situe au niveau du septième noeud N7 correspond à la sortie du circuit et délivre en sortie le signal final Q.

Ainsi, le premier bloc B1 est un multiplexeur à deux étages ET1 et ET2 recevant, en entrée de chaque étage, les données D ou TI suivant le signal de sélection du multiplexeur TE et son inverse TEn. Le multiplexeur est commandé par un signal d'horloge unique Cp. La commande, par une seule phase d'horloge, permet d'éviter une trop grande consommation d'énergie et de réduire le retard du signal d'horloge Cp par rapport à la donnée et de rendre négatif le temps de maintien d'une donnée (hold).

Cependant, la présence d'un seul signal d'horloge n'est possible en régime statique que si l'on met en place un premier transistor T1 à la sortie du premier bloc B1. En effet, lorsque l'activité de l'horloge est trop faible ou à l'arrêt à l'état haut, un court-circuit peut naître si les données D/TI coupent ET1 et laissent établir le potentiel de N1 par les courants de fuite à un niveau intermédiaire induisant un courant de court-circuit dans IV1. Ainsi la mise en place d'un premier transistor T1 entre le troisième noeud commun N3 et la masse permet de fixer un potentiel en tout point du premier bloc B1.

Les données D représentent les données à mémoriser dans la bascule de type maître-esclave formée par les deuxième et troisième blocs B2 et B3. Ainsi après avoir été sélectionnées, via le premier bloc B1, les données D entrent dans le deuxième bloc B2 au front descendant du signal d'horloge puis dans le troisième bloc B3 au front montant du signal d'horloge. L'état est donc mémorisé dans la première boucle de rétroaction formée par la première porte logique P1 et le deuxième inverseur IV2 sur phase basse du signal d'horloge, puis dans la deuxième boucle de rétroaction formée par la deuxième porte P2 et le sixième inverseur IV6 sur phase haute du signal d'horloge. L'ensemble recopie la donnée en entrée sur la sortie sur front montant de l'horloge réalisant la fonction de Flip-Flop désirée.

Il faut toutefois noter qu'en permutant les phases actives de l'horloge, les types P ou N des transistors ou la polarité des alimentations, il est aisé de transformer le dispositif présenté en flip-flop transparente sur front descendant.

De manière similaire au transistor T1, lorsque l'activité de l'horloge est trop faible ou à l'arrêt mais a un niveau bas, le deuxième transistor T2 entre la tension Vdd et la sortie du troisième inverseur IV3, permet d'éviter un court-circuit dû à la présence d'une seule phase d'horloge dans le troisième bloc B3.

Le bloc multiplexeur B1 et le premier inverseur IV1 sont nécessaires à la mise en place d'une mémoire à verrouillage à signal d'horloge selon Svensson. Il en est de même pour les troisième et quatrième inverseurs, respectivement IV3 et IV4. Enfin, afin de conserver la parité des signaux logiques, un cinquième inverseur IV5 est disposé en entrée de la deuxième boucle de rétroaction formée par la deuxième porte P2 et le sixième inverseur IV6.

Un tel dispositif peut être incorporé par exemple dans un circuit à ultra basse consommation.

## Revendications

1. Bascule comprenant un premier étage maître de verrouillage de données (B2), un deuxième étage esclave de verrouillage de données (B3) et un circuit multiplexeur d'entrée (B1) recevant en entrée des données à verrouiller dans la bascule, **caractérisée en ce que** le multiplexeur est un multiplexeur à signal d'horloge unique (Cp), le premier étage maître (B2) étant cadencé à partir d'un premier type de phase du signal d'horloge et le deuxième étage esclave (B3) étant cadencé à partir d'un deuxième type de phase du signal d'horloge.

2. Bascule selon la revendication 1, **caractérisée en ce que** le premier étage maître (B2) comporte une première mémoire de verrouillage (BS1) et un premier inverseur (IV1) en entrée de la première mémoire de verrouillage.

3. Bascule selon l'une des revendications 1 et 2, **caractérisée en ce que** le deuxième étage esclave (B3) comporte une deuxième mémoire de verrouillage (BS2) et des deuxième (IV3) et troisième (IV4) inverseurs en série en entrée de la deuxième mémoire de verrouillage.

4. Bascule selon l'une quelconque des revendications 1 à 3, **caractérisée en ce que** les inverseurs sont des inverseurs MOS.

5. Bascule selon l'une quelconque des revendications 1 et 4, **caractérisée en ce que** la mémoire de verrouillage (BS1) du premier étage maître (B2) comporte un inverseur demi-commandé de rebouclage (IV2) et une porte logique « NON ET » (P1) placés en parallèle.

6. Bascule selon l'une quelconque des revendications 1 à 5, **caractérisée en ce que** la mémoire de verrouillage (BS2) du deuxième étage esclave (B3) comporte un inverseur demi-commandé de rebouclage (IV6) et une porte logique « NON OU » (P2) placés en parallèle.

7. Bascule selon l'une quelconque des revendications 1 à 6, **caractérisée en ce que** les deux mémoires de verrouillage possèdent une fonction d'initialisation asynchrone, de type SET ou RESET indépendant du signal d'horloge (Cp).

8. Bascule selon l'une quelconque des revendications 1 à 7, **caractérisée en ce que** la bascule comporte un transistor NMOS (T1) dépendant du signal d'horloge (Cp) placé entre le multiplexeur (B1) et le premier étage maître (B2).

9. Bascule selon l'une quelconque des revendications 1 à 8, **caractérisée en ce que** la bascule comporte un transistor PMOS (T2) dépendant du signal d'horloge (Cp) placé entre les deux inverseurs du deuxième étage esclave (B3).
